# EUROPÄISCHE PATENTSCHRIFT

(11) **EP 1 192 666 B1**
(45) Veröffentlichungstag und Bekanntmachung des Hinweises auf die Patenterteilung: **24.10.2007**
(21) Anmeldenummer: 00949153.1
(22) Anmeldetag: 05.07.2000
(51) Int. Cl.: H01L 29/51, H01L 29/78, H01L 27/12, H01L 27/115

(54) **SPEICHERZELLENANORDNUNG**
MEMORY CELL ARRANGEMENT
ENSEMBLE CELLULE DE MEMOIRE

(30) Priorität: 06.07.1999 DE 19931124
(43) Veröffentlichungstag der Anmeldung: 03.04.2002
(73) Patentinhaber: Qimonda AG, 81739 München (DE)
(72) Erfinder: HANEDER, Thomas, Peter, 85221 Dachau (DE); BACHHOFER, Harald, D-81677 München (DE)
(74) Vertreter: Epping - Hermann - Fischer
(86) Internationale Anmeldenummer: PCT/DE2000/002190
(87) Internationale Veröffentlichungsnummer: WO 2001/003198

(56) Entgegenhaltungen:
- US-A- 5 361 225
- US-A- 5 471 417
- PATENT ABSTRACTS OF JAPAN vol. 1999, no. 07, 31. März 1999 (1999-03-31) -& JP 07 106450 A (OLYMPUS OPTICAL CO LTD;SYMMETRICS CORP), 21. April 1995 (1995-04-21)

## Beschreibung

Die Erfindung betrifft eine Speicherzellenanordnung zur nichtflüchtigen Speicherung von Daten. Zur nichtflüchtigen Speicherung von Daten sind Speicherzellenanordnungen vorgeschlagen worden, in denen jede Speicherzelle mindestens einen ferroelektrischen Transistor aufweist (siehe EP 0 566 585 B1). Als ferroelektrischer Transistor wird dabei ein Transistor bezeichnet, der zwei Source-/Drain-Gebiete, einen Kanalbereich und eine Gateelektrode aufweist, wobei zwischen der Gateelektrode und dem Kanalbereich eine ferroelektrische Schicht, das heißt eine Schicht aus ferroelektrischem Material, vorgesehen ist. Die Leitfähigkeit dieses Transistors ist von dem Polarisationszustand der Schicht aus ferroelektrischem Material abhängig. Derartige ferroelektrische Transistoren werden im Hinblick auf nichtflüchtige Speicher untersucht. Dabei werden zwei verschiedenen logischen Werten einer digitalen Information zwei verschiedene Polarisationszustände der Schicht aus ferroelektrischem Material zugeordnet.

In der aus EP 0 566 585 B1 bekannten Speicherzellenanordnung wird vorgeschlagen, für die verschiedenen Speicherzellen unterhalb der ferroelektrischen Schicht am Substrat individuell eine Spannung anzulegen, um beim Einschreiben von Information in eine Speicherzelle eine Veränderung der Information in anderen, nicht ausgewählten Speicherzellen zu vermeiden. Dazu wird unterhalb des aktiven Transistorgebietes eine dotierte Schicht vorgesehen, die über pn-Übergänge vom allgemeinen Substrat isoliert ist und über Isolationsbereiche von benachbarten Speicherzellen isoliert ist, die ein individuelles Substrat für den einzelnen ferroelektrischen Transistor darstellt.

Eine andere Speicherzellenanordnung mit ferroelektrischen Transistoren als Speicherzellen ist in T. Nakamura, Y. Nakao, A. Kamisawa, H. Takasu: A Single Transistor Ferroelectric Memory Cell, IEEE, ISSCC, 1995, Seiten 68 bis 69, vorgeschlagen worden. Dabei wird jeder der ferroelektrischen Transistoren zwischen eine Versorgungsspannungsleitung und eine Bitleitung geschaltet. Die Auswahl erfolgt über ein Backgate. Die verwendeten ferroelektrischen Transistoren weisen dabei zwischen der ferroelektrischen Schicht und dem Gateoxid eine Floating-Gateelektrode auf, deren Ladung über den Polarisationszustand der ferroelektrischen Schicht gesteuert wird.

Es hat sich gezeigt, daß in derartigen Speicherzellenanordnungen beim Lesen der Information auch an nicht ausgewählten Speicherzellen eine Spannung abfällt, die zu einer Verfälschung der in den einzelnen Speicherzellen gespeicherten Information führen kann. Diese Verfälschung wird darauf zurückgeführt, daß Umklappprozesse der Domänen in ferroelektrischen Materialien von statistischer Natur sind und bereits bei niedrigen Spannungen hervorgerufen werden können.

Ein weiteres Bauelement ist in JP-A-7 106 450 beschrieben.

Der Erfindung liegt das Problem zugrunde, eine Speicherzellenanordnung anzugeben, die Speicherzellen mit jeweils einem ferroelektrischen Transistor aufweist, in der eine Veränderung der eingeschriebenen Information beim Lesevorgang vermieden wird.

Dieses Problem wird gelöst durch eine Speicherzellenanordnung gemäß Anspruch 1. Weitere Ausgestaltungen der Erfindung gehen aus den übrigen Ansprüchen hervor.

In der Speicherzellenanordnung sind in einem Halbleitersubstrat integriert eine Vielzahl von Speicherzellen vorgesehen, die jeweils einen ferroelektrischen Transistor aufweisen. Der ferroelektrische Transistor umfaßt jeweils zwei Source-/Drain-Gebiete, zwischen denen an der Oberfläche des Halbleitersubstrats eine erste Gatezwischenschicht und eine erste Gateelektrode angeordnet sind, wobei die erste Gatezwischenschicht mindestens eine ferroelektrische Schicht enthält, und zwischen denen in Richtung einer Verbindungslinie zwischen den Source-/Drain-Gebieten neben der ersten Gatezwischenschicht eine zweite Gatezwischenschicht und eine zweite Gateelektrode angeordnet sind, wobei die zweite Gatezwischenschicht eine dielektrische Schicht enthält, wobei die erste Gateelektrode und die zweite Gateelektrode über eine Diodenstruktur miteinander verbunden sind. Ferner sind in der Speicherzellenanordnung im wesentlichen parallel verlaufende Wortleitungen vorgesehen, wobei die zweite Gateelektrode jeweils mit einer der Wortleitungen verbunden ist. In dem Halbleitersubstrat sind darüber hinaus streifenförmige dotierte Wannengebiete vorgesehen, die die Wortleitungen kreuzen und die jeweils im Bereich zwischen den Source-/Drain-Gebieten der ferroelektrischen Transistoren verlaufen.

In dieser Speicherzellenanordnung wird eine der Speicherzellen durch die zugehörige Wortleitung und das zugehörige streifenförmige dotierte Wannengebiet ausgewählt. Die nicht ausgewählten streifenförmigen dotierten Wannengebiete und Wortleitungen werden mit solchen Spannungspegeln beaufschlagt, daß der Polarisationszustand der ferroelektrischen Schicht in den nicht ausgewählten Speicherzellen dabei nicht verändert wird. Das Vorsehen der streifenförmigen dotierten Wannengebiete erlaubt das Anlegen einer individuellen Substratspannung an den entlang des jeweiligen streifenförmigen dotierten Wannengebietes angeordneten ferroelektrischen Transistoren.

Da in dem ferroelektrischen Transistor jeweils nebeneinander entlang der Verbindungslinie zwischen den Source-/Drain-Gebieten die erste Gateelektrode und die zweite Gateelektrode angeordnet sind, ist der Kanalbereich des ferroelektrischen Transistors unterteilt. Ein Teil des Kanalbereichs, der unter der ersten Gateelektrode angeordnet ist, ist durch die an der ersten Gateelektrode wirksame Ladung ansteuerbar. Ein anderer Teil des Kanalbereichs, der unter der zweiten Gateelektrode angeordnet ist, ist durch die an der zweiten Gateelektrode wirksamen Ladung ansteuerbar. Zwischen den Source-/Drain-Gebieten kann nur dann ein Strom fließen, wenn sowohl der Teil des Kanalbereichs unterhalb der ersten Gateelektrode als auch der Teil des Kanalbereichs unterhalb der zweiten Gateelektrode leitend ist.

Die Diodenstruktur ist so gepolt, daß bei Anliegen einer Spannung an der zweiten Gateelektrode, die die Leitfähigkeit des Kanalbereichs unter der zweiten Gateelektrode steuert, die Diodenstruktur sperrt und dadurch die erste Gateelektrode von dieser Spannung getrennt ist. Dadurch wird sichergestellt, daß die Spannung zur Ansteuerung der zweiten Gateelektrode nur über die zweite Gateelektrode abfällt. Die erste Gateelektrode ist über die Diodenstruktur von dieser Spannung getrennt, so daß über die ferroelektrische Schicht in diesem Fall keine Spannung abfällt. Dadurch wird eine Veränderung der Polarisation der ferroelektrischen Schicht und damit der gespeicherten Information beim Lesevorgang, bei dem die zweite Gateelektrode angesteuert wird, vermieden.

Zum Einschreiben und Löschen von Information kann dagegen an die zweite Gateelektrode eine Spannung angelegt werden, die geeignet ist, die ferroelektrische Schicht zu polarisieren. Das Einschreiben der Information erfolgt dabei durch eine Spannung, die größer als die Sperrspannung der Diodenstruktur ist und die die ferroelektrische Schicht in die eine Richtung polarisiert. Das Löschen der Information erfolgt durch eine Spannung mit anderem Vorzeichen, so daß die Diodenstruktur in Durchlaßrichtung gepolt ist und die an der ferroelektrischen Schicht abfallende Spannung diese in die andere Richtung polarisiert.

In der Speicherzellenanordnung ist pro Speicherzelle der ferroelektrische Transistor ausreichend, um Information nichtflüchtig zu speichern und die Information nicht zerstörend auszulesen. Ein zusätzlicher Auswahltransistor ist nicht erforderlich. Die Speicherzellenanordnung ist daher mit reduziertem Platzbedarf realisierbar.

Vorzugsweise sind in der Speicherzellenanordnung entlang einer Wortleitung benachbarte ferroelektrische Transistoren in Reihe verschaltet. Der ferroelektrische Transistor einer der Speicherzellen ist dabei jeweils zwischen benachbarte Bitleitungen geschaltet, zwischen denen beim Lesevorgang ein Stromfluß durch den ferroelektrischen Transistor bewertet wird.

Im Hinblick auf einen reduzierten Flächenbedarf ist es in dieser Ausgestaltung vorteilhaft, die miteinander verbundenen Source-/Drain-Gebiete von entlang einer Wortleitung benachbarten ferroelektrischen Transistoren als gemeinsames Diffusionsgebiet auszubilden. Die Breite der streifenförmigen dotierten Wannengebiete ist in diesem Fall parallel zum Verlauf der Wortleitungen jeweils geringer als der Abstand zwischen den Mitten der Source-/Drain-Gebiete des jeweiligen ferroelektrischen Transistors. Auf diese Weise wird sichergestellt, daß die streifenförmigen dotierten Wannengebiete von entlang einer Wortleitung benachbarten ferroelektrischen Transistoren gegeneinander durch die Dotierung des Halbleitersubstrats isoliert sind und so die zugehörigen ferroelektrischen Transistoren über die jeweiligen streifenförmigen dotierten Wannengebiete eindeutig ansteuerbar sind.

Im Hinblick auf eine sichere Isolation zwischen benachbarten streifenförmigen dotierten Wannengebieten ist es vorteilhaft, die Breite der streifenförmigen dotierten Wannengebiete so groß vorzusehen, daß die beiden Source-/Drain-Gebiete des jeweiligen ferroelektrischen Transistors innerhalb des jeweiligen streifenförmigen dotierten Wannengebietes angeordnet sind. In diesem Fall ist es vorteilhaft, benachbarte streifenförmige dotierte Wannengebiete durch eine dielektrische Isolationsstruktur voneinander zu trennen, die das Auftreten von Latch up Effekten zwischen benachbarten streifenförmigen dotierten Wannengebieten vermeidet.

Vorzugsweise sind die zweite Gatezwischenschicht und die zweite Gateelektrode jeweils aus zwei Teilstrukturen zusammengesetzt, die spiegelsymmetrisch zu der ersten Gatezwischenschicht angeordnet sind. Die beiden Teilstrukturen der zweiten Gateelektrode sind elektrisch miteinander verbunden. Diese Ausgestaltung hat den Vorteil, daß die an der zweiten Gateelektrode anliegende Spannung beim Lesebetrieb ein derartiges elektrisches Feld hervorruft, das die ferroelektrische Schicht auf einer Äquipotentiallinie liegt und somit keinerlei Veränderung der Polarisation der ferroelektrischen Schicht auftritt. Diese Ausgestaltung der Erfindung ist besonders unempfindlich gegenüber Störungen.

Es ist vorteilhaft, zwischen der Oberfläche des Halbleitersubstrats und der ferroelektrischen Schicht eine dielektrische Schicht vorzusehen, die das Aufbringen der ferroelektrischen Schicht erleichtert.

Im Hinblick auf die Herstellung des ferroelektrischen Transistors ist es vorteilhaft, die elektrische Schicht, die in der ersten Gatezwischenschicht zwischen der Halbleiteroberfläche und der ferroelektrischen Schicht angeordnet ist, und die dielektrische Schicht, die Bestandteil der zweiten Gatezwischenschicht ist, als durchgehende dielektrische Schicht zu bilden, an deren Oberfläche der Stapel aus ferroelektrischer Schicht und erster Gateelektrode erzeugt wird.

Vorzugsweise sind die erste Gateelektrode und/oder die zweite Gateelektrode Teil der Diodenstruktur. Auf diese Weise sinkt der Platzbedarf der Diodenstruktur.

Vorzugsweise weist die erste Gateelektrode polykristallines Silizium auf, das von einem ersten Leitfähigkeitstyp dotiert ist. Die zweite Gateelektrode weist ebenfalls polykristallines Silizium auf, das von einem zweiten, dem ersten entgegengesetzten Leitfähigkeitstyp dotiert ist. Die erste Gateelektrode grenzt dabei an die zweite Gateelektrode an, so daß die Diodenstruktur durch die erste Gateelektrode und die zweite Gateelektrode gebildet wird. In dieser Ausgestaltung sind zum Betrieb des ferroelektrischen Transistors nur vier Anschlüsse erforderlich, zwei an den Source-/Drain-Gebieten, einer an der zweiten Gateelektrode und einer zu dem streifenförmigen dotierten Wannengebiet. Alternativ können in dieser Ausgestaltung die erste Gateelektrode und die zweite Gateelektrode jeweils aus entsprechend dotiertem epitaktisch aufgewachsenem Silizium gebildet werden.

Aus technologischen Gründen kann es vorteilhaft sein, zwischen der ferroelektrischen Schicht und der ersten Gateelektrode eine Hilfsschicht zum Beispiel aus Platin oder aus dielektrischem Material zum Beispiel aus CeO₂, ZrO₂ oder dergleichen , ca. 2 bis 10 nm dick, vorzusehen, die unerwünschte Eigenschaften der ferroelektrischen Schicht wie zum Beispiel fatigue oder imprint resistance vermeidet. Wird die Hilfsschicht aus leitendem Material gebildet, so wird sie gegen die zweite Gateelektrode isoliert.

Es liegt im Rahmen der Erfindung, ein Halbleitersubstrat zu verwenden, das zumindest im Bereich der aktiven Gebiete der ferroelektrischen Transistoren monokristallines Silizium aufweist. Insbesondere ist als Halbleitersubstrat eine monokristalline Siliziumscheibe oder die monokristalline Siliziumschicht eines SOI-Substrats geeignet. Darüber hinaus sind alle Halbleitersubstrate geeignet, die zur Herstellung integrierter Schaltungen in Frage kommen.

Es liegt im Rahmen der Erfindung, daß die erste Gatezwischenschicht eine dielektrische Schicht aus CeO₂, ZrO₂, Y₂O₃ oder einem anderen Oxid mit möglichst großer dielektrischer Suszeptibilität wie zum Beispiel SrTiO₃ enthält. Für die dielektrische Schicht in der zweiten Gatezwischenschicht ist insbesondere SiO₂, CeO₂, ZrO₂, Y₂O₃ oder ein anderes Oxid mit möglichst großer dielektrischer Suszeptibilität wie zum Beispiel SrTiO₃ geeignet. Die ferroelektrische Schicht kann unter anderem aus Strontium-Wismuth-Tantalat (SBT), Blei-Zirkonium-Titanat (PZT), Lithium-Niobat (LiNbO₃) oder Barium-Strontium-Titanat (BST) sein.

Im folgenden wird die Erfindung anhand von Ausführungsbeispielen, die in den Figuren dargestellt sind, näher erläutert. Die Darstellungen in den Figuren sind nicht maßstäblich.
- Figur 1: zeigt einen Schnitt durch eine Speicherzellenanordnung, in der als Speicherzellen ferroelektrische Transistoren verwendet werden, die jeweils in einem streifenförmigen dotierten Wannengebiet angeordnet sind.
- Figur 2: zeigt einen Schnitt durch eine Speicherzellenanordnung, die als Speicherzellen ferroelektrische Transistoren aufweist, wobei benachbarte ferroelektrische Transistoren, die in Reihe verschaltet sind, ein gemeinsames Source-/Drain-Gebiet aufweisen.
- Figur 3: zeigt ein Schaltsymbol für einen ferroelektrischen Transistor mit einer ersten Gateelektrode und einer zweiten Gateelektrode, zwischen denen eine Diodenstruktur wirksam ist.
- Figur 4: zeigt eine Schaltskizze für eine Speicherzellenanordnung.

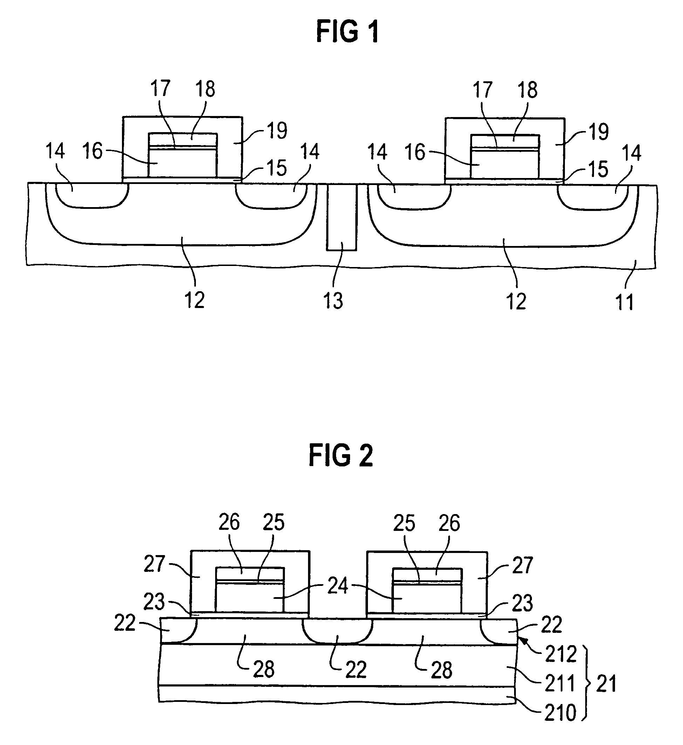

In einem Halbleitersubstrat 11 aus Phosphor-dotiertem, monokristallinem Silizium sind streifenförmige dotierte Wannengebiete 12 angeordnet, die p-dotiert mit einer Dotierstoffkonzentration von einigen 10¹⁶ cm⁻³ und einer Randdotierung von ca. 5 x 10¹⁷ cm⁻³ sind (siehe Figur 1). Die streifenförmigen dotierten Wannengebiete 12 weisen parallel zur Oberfläche des Halbleitersubstrats 11 einen der jeweiligen Technologiegeneration entsprechenden Querschnitt. Benachbarte streifenförmige dotierte Wannengebiete 12 sind durch eine dielektrische Isolationsstruktur 13 gegeneinander isoliert. Die dielektrische Isolationsstruktur 13 ist als mit isolierendem Material gefüllter Graben im Sinne einer sogenannten Shallow Trench Isolation realisiert.

In den streifenförmigen dotierten Wannengebieten 12 sind jeweils ferroelektrische Transistoren angeordnet, die jeweils zwei Source-/Drain-Gebiete 14 aufweisen, die in Richtung der geringeren Abmessung des streifenförmigen dotierten Wannengebietes 12 nebeneinander angeordnet sind. Der Bereich zwischen den beiden Source-/Drain-Gebieten 14 wirkt als Kanalbereich. Die Source-/Drain-Gebiete 14 sind n⁺-dotiert.

An der Oberfläche des Kanalbereichs ist eine dielektrische Schicht 15 angeordnet, die eine Schichtdicke von 5 bis 10 nm aufweist und die aus CeO₂ oder ZrO₂ ausgebildet ist.

An der Oberfläche der dielektrischen Schicht 15 ist eine ferroelektrische Schicht 16 angeordnet, deren Querschnitt parallel zur Oberfläche des Substrats 11 kleiner als der der dielektrischen Schicht 15 ist. Die dielektrische Schicht 15 überragt die ferroelektrische Schicht 16 seitlich. An der Oberfläche der ferroelektrischen Schicht 16 ist eine Hilfsschicht 17 und an der Oberfläche der Hilfsschicht 17 eine erste Gateelektrode 18 angeordnet. Darüber hinaus ist eine zweite Gateelektrode 19 vorgesehen, die beiderseits der ferroelektrischen Schicht 16 auf die Oberfläche der dielektrischen Schicht 15 trifft und die die erste Gateelektrode 18 überdeckt.

Die ferroelektrische Schicht 16 weist eine Dicke von 50 bis 100 nm auf und enthält Strontium-Wismuth-Tantalat (SBT) oder Blei-Zirkonium-Titanat (PZT). Die erste Gateelektrode 18 ist aus p⁺-dotiertem Polysilizium mit einer Dotierstoffkonzentration von einigen 10¹⁶ bis 10¹⁷ cm⁻³ gebildet. Die Hilfsschicht 17 ist in einer Dicke von 2 bis 10 nm aus CeO₂ oder ZrO₂ gebildet. Die zweite Gateelektrode 19 ist aus n⁺-dotiertem Polysilizium mit einer Dotierstoffkonzentration von einigen 10¹⁶ bis 10¹⁷ cm⁻³ gebildet. Die erste Gateelektrode 18 und die zweite Gateelektrode 19 bilden gemeinsam eine Diodenstruktur.

In einer alternativen Ausführungsform sind in einem Halbleitersubstrat 21 ferroelektrische Transistoren in Zeilen und Spalten angeordnet, wobei entlang einer Zeile benachbarte ferroelektrische Transistoren in Reihe verschaltet sind. Die ferroelektrischen Transistoren weisen jeweils zwei Source-/Drain-Gebiete 22 auf, zwischen denen an der Oberfläche des Halbleitersubstrats 21 eine dielektrische Schicht 23 angeordnet ist (siehe Figur 2). Das Halbleitersubstrat 21 ist ein SOI-Substrat mit einer monokristallinen Siliziumscheibe 210, auf der eine vergrabene SiO₂-Schicht 211 und eine monokristalline Siliziumschicht 212 angeordnet sind. Die Source-/Drain-Gebiete 22 sind n-dotiert mit einer Dotierstoffkonzentration von einigen 10²⁰ cm⁻³. Die Source-/Drain-Gebiete 22 reichen bis auf die vergrabene SiO₂-Schicht 211. Die dielektrische Schicht 23 weist eine Schichtdicke von 5 bis 10 nm auf und ist aus CeO₂ oder ZrO₂ ausgebildet.

An der Oberfläche der dielektrischen Schicht 23 ist eine ferroelektrische Schicht 24 aus Strontium-Wismuth-Tantalat (SBT) oder Blei-Zirkonium-Titanat (PZT) in einer Schichtdicke von 50 bis 100 nm angeordnet. Der Querschnitt der ferroelektrischen Schicht 24 parallel zur Oberfläche des Substrats 21 ist kleiner als der der dielektrischen Schicht 23, so daß die dielektrische Schicht 23 die ferroelektrische Schicht 24 seitlich überragt.

An der Oberfläche der ferroelektrischen Schicht 24 ist eine Hilfsschicht 25 aus CeO₂ oder ZrO₂ in einer Dicke von 2 bis 10 nm und an der Oberfläche der Hilfsschicht 25 eine erste Gateelektrode 26 aus p⁺-dotiertem Polysilizium mit einer Dotierstoffkonzentration von einigen 10¹⁶ bis 10¹⁷ cm⁻³ angeordnet. Die erste Gateelektrode 26 weist eine Dicke von 50 bis 100 nm auf. Oberhalb der dielektrischen Schicht 23 ist eine zweite Gateelektrode 27 aus n⁺-dotiertem Polysilizium mit einer Dotierstoffkonzentration von einigen 10¹⁶ bis 10¹⁷ cm⁻³ angeordnet. Die zweite Gateelektrode 27 überdeckt die erste Gateelektrode 26, so daß sie in dem in Figur 2 dargestellten Schnitt einen U-förmigen Querschnitt aufweist. Dadurch sind die beiden Teile der zweiten Gateelektrode 27, die an der Oberfläche der dielektrischen Schicht 23 angeordnet sind, miteinander verbunden. Die erste Gateelektrode 26 und die zweite Gateelektrode 27 bilden gemeinsam eine Diodenstruktur.

Zwischen den Source-/Drain-Gebieten 22 ist in der monokristallinen Siliziumschicht 212 jeweils ein streifenförmiges dotiertes Wannengebiet 28 angeordnet, das p-dotiert mit einer Dotierstoffkonzentration von einigen 10¹⁶ cm⁻³ mit einer Kanalimplantation von ca. 5 x 10¹⁷ cm⁻³ ist. Die Breite der streifenförmigen dotierten Wannengebiete 28 ist so gemessen, daß benachbarte streifenförmige dotierte Wannengebiete 28, die jeweils an ein als gemeinsames Diffusionsgebiet ausgebildetes Source-/Drain-Gebiet 22 angrenzen, durch die vergrabene SiO₂-Schicht 211 voneinander und gegeneinander isoliert sind.

Wird die Hilfsschicht 17 bzw. 25 aus einem Metall, zum Beispiel Platin gebildet, so wird sie zum Beispiel durch SiO₂-Spacer gegen die zweite Gateelektrode 19 bzw. 27 isoliert.

Die Hilfsschicht 17 bzw. 25 kann auch so ausgestaltet sein, daß sie die ferroelektrische Schicht 16 bzw. 24 oben und seitlich bedeckt.

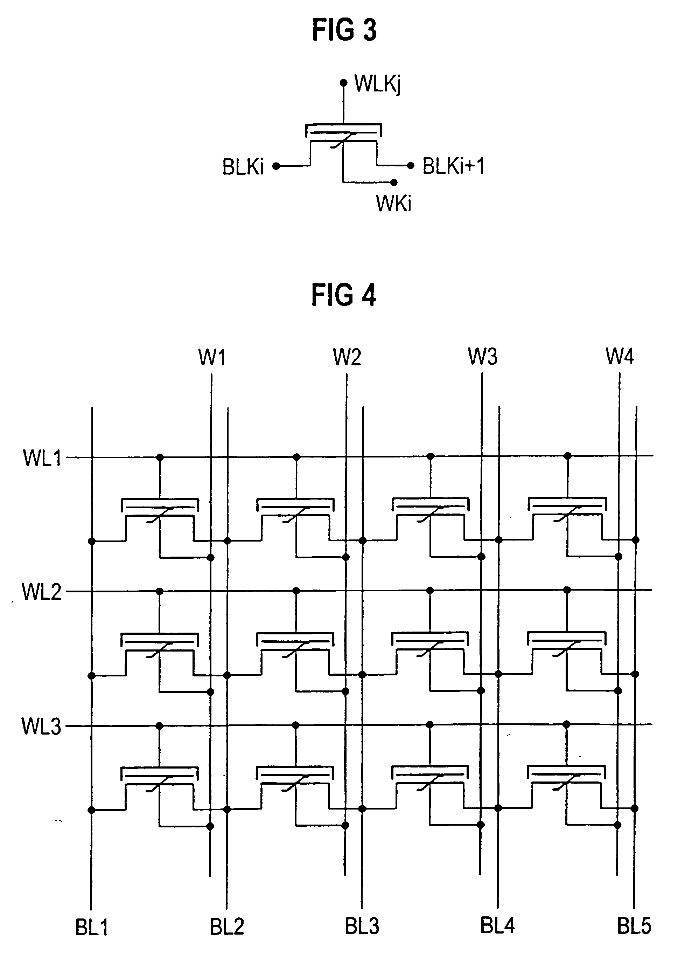

In Figur 3 ist ein Schaltsymbol dargestellt, das im folgenden für einen ferroelektrischen Transistor, wie er anhand von Figur 1 und Figur 2 erläutert wurde, verwendet wird. Der ferroelektrische Transistor weist zwei Bitleitungskontakte BLKi, BLKi+1 auf, die mit den beiden Source-/Drain-Gebieten 14 bzw. 22 verbunden sind. Ferner weist der ferroelektrische Transistor einen Wortleitungskontakt WLKi auf, der mit der zweiten Gateelektrode 19 bzw. 27 verbunden ist. Darüber hinaus weist der ferroelektrische Transistor einen Wannenkontakt WKi auf, der mit dem streifenförmigen dotierten Wannengebiet 28 bzw. 12 verbunden ist oder der durch das streifenförmige dotierte Wannengebiet 28 bzw. 12 gebildet wird.

In der Speicherzellenanordnung sind die Wortleitungskontakte WLKj mit den zugeordneten Wortleitungen WLj verbunden (siehe Figur 4, in der die Bezugszeichen der Kontakte des ferroelektrischen Transistors der Übersichtlichkeit halber nicht eingetragen sind). Jeder der ferroelektrischen Transistoren ist über seine Bitleitungskontakte BLKi, BLKi+1 zwischen benachbarte Bitleitungen BLi, BLi+1 geschaltet. Die Bitleitungen BLi kreuzen die Wortleitungen WLj. Ferner sind die Wannenkontakte WKi der ferroelektrischen Transistoren mit den streifenförmigen dotierten Wannengebieten Wi verbunden. Die streifenförmigen dotierten Wannengebiete Wi verlaufen parallel zu den Bitleitungen BLi und kreuzen die Wortleitungen WLj.

Die Auswahl einer Speicherzelle erfolgt über die Wortleitungen WLj und die diese kreuzenden streifenförmigen dotierten Wannengebiete Wi. Soll eine Speicherzelle ausgelesen werden, so müssen zusätzlich die Bitleitungen BLi, BLi+1, zwischen die die entsprechende Speicherzelle geschaltet ist, ausgewählt werden.

Das Auslesen einer Speicherzelle erfolgt über eine Durchgangsprüfung zwischen den entsprechenden Bitleitungen BLi, BLi+1. Dazu wird die zweite Gateelektrode durch eine positive Spannung, die größer als die Schwellenspannung ist, in Inversion gebracht. Alle anderen Speicherzellen entlang dieser Bitleitung sind nicht ausgewählt und sperren deshalb im Bereich unterhalb der zweiten Gateelektrode. Ein Strom zwischen den Bitleitungen BLi, BLi+1, zwischen die die ausgewählte Speicherzelle geschaltet ist, kann daher nur fließen, wenn die ferroelektrische Schicht des zugehörigen ferroelektrischen Transistors so polarisiert ist, daß der Bereich unterhalb der ersten Gateelektrode leitet. Das streifenförmige dotierte Wannengebiet Wi der ausgewählten Zelle, sowie alle übrigen Zellen werden mit 0 Volt (Ruhepotential) beaufschlagt.

Die Auswahl einer Speicherzelle zum Schreiben erfolgt über die zugeordnete Wortleitung WLj und das zugehörige streifenförmige dotierte Wannengebiet Wi. Die Wortleitung WLj wird auf eine positive Spannung gelegt, zum Beispiel 1,5 Volt, das streifenförmige dotierte Wannengebiet Wi auf eine negative Spannung, zum Beispiel - 1,5 Volt. Der über der ferroelektrischen Schicht angeordnet pn-Übergang zwischen der ersten Gateelektrode und der zweiten Gateelektrode, die ferroelektrische Schicht und die unter der ferroelektrischen Schicht angeordnete dielektrische Schicht stellen eine Reihenschaltung von Kapazitäten dar, sofern der pn-Übergang zwischen der ersten Gatelektrode und der zweiten Gateelektrode in Sperrichtung unterhalb der Durchbruchsspannung betrieben wird.

Zum Schreiben der Speicherzellen wird die Spannung, die der Differenz der Spannungswerte an der Wortleitung WLj und dem streifenförmigen dotierten Wannengebiet Wi entspricht und die an der Reihenschaltung der Kapazitäten anliegt, so gewählt, daß der pn-Übergang zwischen der ersten Gateelektrode und der zweiten Gateelektrode durchbricht. Die Durchbruchsspannung wird zum Beispiel durch die Beschaffenheit der Grenzfläche zwischen p- und n-Gebiet in diesem Beispiel auf 2,1 bis 2,3 V eingestellt. Die angelegte Spannung fällt somit an der ferroelektrischen Schicht, der darunter angeordneten dielektrischen Schicht und dem Substrat ab. Die Spannung über der ferroelektrischen Schicht beträgt somit etwa 1 Volt, dieses ist ausreichend, um die ferroelektrische Schicht in die eine Richtung zu polarisieren. Dadurch wird die ausgewählte Speicherzelle geschrieben.

Die streifenförmigen dotierten Wannengebiete von Zellen, die entlang einer Wortleitung benachbart sind, werden mit 0 Volt (Ruhepotential) beaufschlagt. Entlang der streifenförmigen dotierten Wannengebiete benachbarte Speicherzellen werden an der Wortleitung mit 0 Volt (Ruhepotential) beaufschlagt. Daher fällt über diese Zellen nur eine Spannung, die der Differenz zwischen dem Ruhepotential und 1,5 Volt bzw. dem Ruhepotential und - 1,5 Volt entspricht ab. Diese Spannung ist so gering, daß der pn-Übergang zwischen der ersten Gateelektrode und der zweiten Gateelektrode in diesen Zellen noch sperrt. Da der pn-Übergang im Vergleich zu der ferroelektrischen Schicht, der dielektrischen Schicht und dem Halbleitersubstrat nur eine kleine Kapazität darstellt, etwa einen Faktor 50 bis 100 geringer, ist damit gewährleistet, daß die über dem pn-Übergang, der ferroelektrischen Schicht, der dielektrischen Schicht und dem Halbleitersubstrat abfallende Spannung vor allem über dem pn-Übergang abfällt. Beträgt die Spannung insgesamt 1,5 Volt, so fällt der größte Teil der Spannung, 1,475 Volt, über dem aus erster Gateelektrode und zweiter Gateelektrode gebildeten pn-Übergang ab. Nur ein sehr geringer Teil von etwa 25 mV fällt dagegen über die ferroelektrische Schicht und die dielektrische Schicht ab. Experimente haben gezeigt, daß für eine ferroelektrische Schicht aus Strontium-Wismuth-Tantalat (SBT) in einer Dicke von 180 nm 10¹⁰ Rechteckspannungspulse mit einer Spannung von 50 mV nicht ausreichen, um den Polarisationszustand der ferroelektrischen Schicht zu verändern. Daher ist in dieser Betriebsweise und in der vorgeschlagenen Speicherzellenanordnung sichergestellt, daß mindestens 10¹⁰ Schreibzyklen einer Zelle möglich sind, ohne daß die Information der Nachbarspeicherzellen beeinflußt wird.

Speicherzellen, die mit anderen Wortleitungen WLk und anderen streifenförmigen dotierten Wannengebieten Wl als die ausgewählte Speicherzelle verbunden sind, werden sowohl an der Wortleitung WLk als auch dem streifenförmigen dotierten Wannengebiet Wl mit Ruhepotential beaufschlagt und werden deshalb beim Schreibvorgang nicht beeinflußt.

Zum Löschen einer Speicherzelle erfolgt die Auswahl der Speicherzelle wieder über die Wortleitung WLj und das streifenförmige dotierte Wannengebiet Wi. Die Wortleitung WLj wird auf eine negative Spannung, zum Beispiel - 1,5 Volt gelegt, das streifenförmige dotierte Wannengebiet Wi wird mit Ruhepotential 0 Volt verbunden. Der über der ferroelektrischen Schicht befindliche pn-Übergang, der aus der ersten Gateelektrode und der zweiten Gateelektrode gebildet wird, ist damit in Durchlaßrichtung gepolt, so daß sich die angelegte Spannung auf die ferroelektrische Schicht und die dielektrische Schicht verteilt. Die Schichtdicken werden so aufeinander abgestimmt, daß sich die Spannung gleichmäßig auf die beiden Schichten verteilt. Damit wird die ferroelektrische Schicht in die entgegengesetzte Richtung wie beim Schreibvorgang polarisiert.

Beim Löschen einer Speicherzelle werden mit dem gleichen streifenförmigen Gebiet verbundene benachbarte Speicherzellen über die Wortleitung mit Ruhepotential 0 Volt verbunden, so daß über diese keine Spannung abfällt. Mit derselben Wortleitung WLj verbundene benachbarte Speicherzellen werden über das zugehörige streifenförmige dotierte Wannengebiet Wi mit der negativen Spannung von - 1,5 Volt verbunden, so daß über diese Zellen ebenfalls keine Spannung abfällt, da die Differenz aus Spannung an der Wortleitung WLj und Spannung an dem streifenförmigen dotierten Wannengebiet Wi 0 ist.

Benachbarte Speicherzellen, die mit anderen Wortleitungen WLk und anderen dotierten streifenförmigen Wannengebieten Wl verbunden sind, werden dabei nur mit einer Spannung beaufschlagt, die geringer als die Durchbruchsspannung des aus erster Gateelektrode und zweiter Gateelektrode gebildeten pn-Übergangs ist. Der pn-Übergang ist somit in Sperrichtung gepolt und es fällt der größte Teil der Spannung über dem pn-Übergang ab. Wie anhand des Beispiels des Schreibens einer Speicherzelle abgeschätzt, ist die Spannung, die über die ferroelektrische Schicht dabei abfällt, so gering, daß mindestens 10¹⁰ Löschzyklen einer Zelle möglich sind, ohne die Information der benachbarten Speicherzellen zu beeinflussen.

## Patentansprüche

1. Speicherzellenanordnung mit einem ferroelektrischen Transistor
- bei der in einem Halbleitersubstrat (11) integriert eine Vielzahl Speicherzellen vorgesehen sind, die jeweils einen ferroelektrischen Transistor aufweisen,
- bei der der ferroelektrische Transistor jeweils ein erstes Source-/Drain-Gebiet (14) und ein zweites Source-/Drain-Gebiet (14) umfaßt, zwischen denen an der Oberfläche des Halbleitersubstrats (11) eine erste Gatezwischenschicht und eine erste Gateelektrode (18) angeordnet sind, wobei die erste Gatezwischenschicht mindestens eine ferroelektrische Schicht (16) enthält, und zwischen denen in Richtung einer Verbindungslinie zwischen den Source-/Drain-Gebieten (14) neben der ersten Gatezwischenschicht eine zweite Gatezwischenschicht und eine zweite Gateelektrode (19) angeordnet sind, wobei die zweite Gatezwischenschicht eine dielektrische Schicht (15) enthält, wobei die erste Gateelektrode (18) und die zweite Gateelektrode (19) über eine Diodenstruktur miteinander verbunden sind,
- bei der im wesentlichen parallel verlaufende Wortleitungen (WLj) vorgesehen sind,
- bei der die zweite Gateelektrode (19) jeweils mit einer der Wortleitungen (WLj) verbunden ist,
- bei der im Halbleitersubstrat (11) streifenförmige dotierte Wannengebiete (12) vorgesehen sind, die die Wortleitungen (WLj) kreuzen und die jeweils im Bereich zwischen den Source-/Drain-Gebieten (14) der ferroelektrischen Transistoren verlaufen.

2. Speicherzellenanordnung nach Anspruch 1,
- bei der Bitleitungen vorgesehen sind,
- bei der entlang einer Wortleitung benachbarte ferroelektrische Transistoren in Reihe verschaltet sind,
- bei der der ferroelektrische Transistor einer der Speicherzellen jeweils zwischen benachbarte Bitleitungen geschaltet ist.

3. Speicherzellenanordnung nach Anspruch 2,
- bei der miteinander verbundene Source-/Drain-Gebiete (22) von entlang einer Wortleitung benachbarten ferroelektrische Transistoren als gemeinsames Diffusionsgebiet ausgebildet sind,
- bei der die Breite der streifenförmigen dotierten Wannengebiete (28) parallel zum Verlauf der Wortleitungen jeweils geringer als der Abstand zwischen den Mitten der Source-/Drain-Gebiete des jeweiligen ferroelektrischen Transistors ist.

4. Speicherzellenanordnung nach Anspruch 2,
bei der die Breite der streifenförmigen dotierten Wannengebiete (12) so groß ist, daß die beiden Source-/Drain-Gebiete (14) des jeweiligen Transistors innerhalb des jeweiligen streifenförmigen Wannengebietes (12) angeordnet sind.

5. Speicherzellenanordnung nach Anspruch 4,
bei der zwischen benachbarten streifenförmigen dotierten Wannengebieten (12) eine dielektrische Isolationsstruktur (13) vorgesehen ist.

6. Speicherzellenanordnung nach einem der Ansprüche 1 bis 5, bei der die zweite Gatezwischenschicht und die zweite Gateelektrode des jeweiligen ferroelektrischen Transistors jeweils aus zwei Teilstrukturen zusammengesetzt sind, die spiegelsymmetrisch zu der ersten Gateelektrode angeordnet sind, wobei die beiden Teilstrukturen der zweiten Gateelektrode (19) elektrisch miteinander verbunden sind.

7. Speicherzellenanordnung nach einem der Ansprüche 1 bis 6, bei der die erste Gatezwischenschicht des jeweiligen ferroelektrischen Transistors eine dielektrische Schicht enthält, die zwischen der Oberfläche des Halbleitersubstrats (11) und der ferroelektrischen Schicht (16) angeordnet ist.

8. Speicherzellenanordnung nach Anspruch 7,
bei der die dielektrische Schicht (15) der ersten Gatezwischenschicht und die dielektrische Schicht (15) der zweiten Gatezwischenschicht des jeweiligen ferroelektrischen Transistors als durchgehende dielektrische Schicht (15) ausgestaltet sind.

9. Speicherzellenanordnung nach einem der Ansprüche 1 bis 8, bei der die erste Gateelektrode (18) und/oder die zweite Gateelektrode (19) des jeweiligen ferroelektrischen Transistors Teil der Diodenstruktur sind.

10. Speicherzellenanordnung nach Anspruch 9,
- bei der die erste Gateelektrode (18) polykristallines Silizium, das von einem ersten Leitfähigkeitstyp dotiert ist, aufweist,
- bei der die zweite Gateelektrode des jeweiligen Transistors (19) polykristallines Silizium, das von einem zweiten, dem ersten entgegengesetzten Leitfähigkeitstyp dotiert ist, aufweist,
- bei der die erste Gateelektrode (18) an die zweite Gateelektrode (19) angrenzt.

11. Speicherzellenanordnung nach einem der Ansprüche 1 bis 10,
bei der in dem jeweiligen ferroelektrischen Transistor zwischen der ferroelektrischen Schicht (16) und der ersten Gateelektrode (18) eine Hilfsschicht (17) vorgesehen ist.

12. Speicherzellenanordnung nach einem der Ansprüche 1 bis 11,
bei der in dem jeweiligen ferroelektrischen Transistor die erste Gatezwischenschicht CeO₂, ZrO₂, Y₂O₃ oder SrTiO₃, die zweite Gatezwischenschicht SiO₂, CeO₂, ZrO₂ oder SrTiO₃, die ferroelektrische Schicht (16) Strontium-Wismuth-Tantalat (SBT), Blei-Zirkon-Titanat (PZT), Lithium-Niobat (LiNbO₃) oder Barium-Strontium-Titanat (BST) und das Halbleitersubstrat (11) monokristallines Silizium enthält.

## Claims

1. Memory cell arrangement with a ferroelectric transistor,
- in which a multiplicity of memory cells, each having a ferroelectric transistor, are provided in an integrated manner in a semiconductor substrate (11),
- in which the ferroelectric transistor in each case comprises a first source/drain region (14) and a second source/drain region (14), between which a first gate intermediate layer and a first gate electrode (18) are arranged at the surface of the semiconductor substrate (11), the first gate intermediate layer containing at least one ferroelectric layer (16), and between which a second gate intermediate layer and a second gate electrode (19) are arranged in the direction of a connecting line between the source/drain regions (14), beside the first gate intermediate layer, the second gate intermediate layer containing a dielectric layer (15), the first gate electrode (18) and the second gate electrode (19) being connected to one another via a diode structure,
- in which word lines (WLj) which essentially run parallel are provided,
- in which the second gate electrode (19) is in each case connected to one of the word lines (WLj),
- in which strip-type doped well regions (12) are provided in the semiconductor substrate (11), which well regions cross the word lines (WLj) and in each case run in the region between the source/drain regions (14) of the ferroelectric transistors.

2. Memory cell arrangement according to Claim 1,
- in which bit lines are provided,
- in which adjacent ferroelectric transistors along a word line are connected up in series,
- in which the ferroelectric transistor of one of the memory cells is in each case connected between adjacent bit lines.

3. Memory cell arrangement according to Claim 2,
- in which interconnected source/drain regions (22) of adjacent ferroelectric transistors along a word line are formed as a common diffusion region,
- in which the width of the strip-type doped well regions (28) parallel to the course of the word lines is in each case less than the distance between the centers of the source/drain regions of the respective ferroelectric transistor.

4. Memory cell arrangement according to Claim 2,
in which the width of the strip-type doped well regions (12) is so large that the two source/drain regions (14) of the respective transistor are arranged within the respective strip-type well region (12).

5. Memory cell arrangement according to Claim 4,
in which a dielectric isolation structure (13) is provided between adjacent strip-type doped well regions (12).

6. Memory cell arrangement according to one of Claims 1 to 5,
in which the second gate intermediate layer and the second gate electrode of the respective ferroelectric transistor are in each case composed of two partial structures which are arranged mirror-symmetrically with respect to the first gate electrode, the two partial structures of the second gate electrode (19) being electrically connected to one another.

7. Memory cell arrangement according to one of Claims 1 to 6,
in which the first gate intermediate layer of the respective ferroelectric transistor contains a dielectric layer which is arranged between the surface of the semiconductor substrate (11) and the ferroelectric layer (16).

8. Memory cell arrangement according to Claim 7, in which the dielectric layer (15) of the first gate intermediate layer and the dielectric layer (15) of the second gate intermediate layer of the respective ferroelectric transistor are configured as a continuous dielectric layer (15).

9. Memory cell arrangement according to one of Claims 1 to 8,
in which the first gate electrode (18) and/or the second gate electrode (19) of the respective ferroelectric transistor are part of the diode structure.

10. Memory cell arrangement according to Claim 9,
- in which the first gate electrode (18) has polycrystalline silicon doped by a first conductivity type,
- in which the second gate electrode of the respective transistor (19) has polycrystalline silicon doped by a second conductivity type, which is opposite to the first conductivity type,
- in which the first gate electrode (18) adjoins the second gate electrode (19).

11. Memory cell arrangement according to one of Claims 1 to 10, in which an auxiliary layer (17) is provided in the respective ferroelectric transistor between the ferroelectric layer (16) and the first gate electrode (18).

12. Memory cell arrangement according to one of Claims 1 to 11,
in which, in the respective ferroelectric transistor, the first gate intermediate layer contains CeO₂, ZrO₂, Y₂O₃ or SrTiO₃, the second gate intermediate layer contains SiO₂, CeO₂, ZrO₂ or SrTiO₃, the ferroelectric layer (16) contains strontium bismuth tantalate (SBT), lead zirconium titanate (PZT), lithium niobate (LiNbO₃) or barium strontium titanate (BST), and the semiconductor substrate (11) contains monocrystalline silicon.

## Revendications

1. Dispositif de cellule de mémoire ayant un transistor ferroélectrique
- dans lequel il est prévu, intégré dans un substrat (11) semi-conducteur, une pluralité de cellules de mémoire qui ont, respectivement, un transistor ferroélectrique,
- dans lequel le transistor ferroélectrique comprend, respectivement, une première zone (14) de source/drain et une deuxième zone (14) de source/drain entre lesquelles sont disposées à la surface du substrat (11) semi-conducteur, une première couche intermédiaire de grille et une première électrode (18) de grille, la première couche intermédiaire de grille contenant au moins une couche (16) ferroélectrique et entre lesquelles sont disposées, dans la direction d'une ligne de liaison entre les zones (14) de source/drain, à côté de la première couche intermédiaire de grille, une deuxième couche intermédiaire de grille et une deuxième électrode (19) de grille, la deuxième couche intermédiaire de grille contenant une couche (15) diélectrique, la première électrode (18) de grille et la deuxième électrode (19) de grille étant reliées entre elles par une structure de diodes,
- dans lequel il est prévu des lignes (WLj) de mots s'étendant de façon sensiblement parallèle,
- dans lequel la deuxième électrode (19) de grille est reliée respectivement à l'une des lignes (WLj) de mots,
- dans lequel il est prévu, dans le substrat (11) semi-conducteur des zones (12) de caisson dopées en forme de bandes qui croisent les lignes (WLj) de mots et qui s'étendent, respectivement, dans la partie comprise entre les zones (14) de source/drain des transistors ferroélectriques.

2. Dispositif de cellule de mémoire suivant la revendication 1,
- dans lequel il est prévu des lignes de bits,
- dans lequel des transistors ferroélectriques voisins sont montés en série le long d'une ligne de mots,
- dans lequel le transistor ferroélectrique de l'une des cellules de mémoire est monté, respectivement, entre des lignes de bits voisines.

3. Dispositif de cellule de mémoire suivant la revendication 2,
- dans lequel des zones (22) de source/drain reliées entre elles de transistors ferroélectriques voisins le long d'une ligne de mots sont constituées sous la forme d'une zone de diffusion commune,
- dans lequel la largeur des zones (28) de caissons dopées en forme de bandes, parallèlement à l'étendue des lignes de mots, est respectivement plus petite que la distance entre les milieux des zones de source/drain du transistor ferroélectrique respectif.

4. Dispositif de cellule de mémoire suivant la revendication 2,
dans lequel la largeur des zones (12) de caissons dopées en forme de bandes est si grande que les deux zones (14) de source/drain du transistor respectif sont disposées à l'intérieur de la zone (12) de caisson en forme de bande respective.

5. Dispositif de cellule de mémoire suivant la revendication 4,
dans lequel il est prévu une structure (13) diélectrique d'isolement entre des zones (12) de caissons voisines dopées en forme de bandes.

6. Dispositif de cellule de mémoire suivant l'une des revendications 1 à 5,
dans lequel la deuxième couche intermédiaire de grille et la deuxième électrode de grille du transistor ferroélectrique respectif sont composées, respectivement, de deux sous-structures qui sont symétriques comme en un miroir par rapport à la première électrode de grille, les deux sous-structures de la deuxième électrode (19) de grille étant reliées électriquement entre elles.

7. Dispositif de cellule de mémoire suivant l'une des revendications 1 à 6,
dans lequel la première couche intermédiaire de grille du transistor ferroélectrique respectif contient une couche diélectrique qui est disposée entre la surface du substrat (11) semi-conducteur et la couche (16) ferroélectrique.

8. Dispositif de cellule de mémoire suivant la revendication 7,
dans lequel la couche (15) diélectrique de la première couche intermédiaire de grille et la couche (15) diélectrique de la deuxième couche intermédiaire de grille du transistor ferroélectrique respectif sont conformées en couche (15) diélectrique continue.

9. Dispositif de cellule de mémoire suivant l'une des revendications 1 à 8,
dans lequel la première électrode (18) de grille et/ou la deuxième électrode (19) de grille du transistor ferroélectrique respectif font partie de la structure de diodes.

10. Dispositif de cellule de mémoire suivant la revendication 9,
- dans lequel la première électrode (18) de grille a du silicium polycristallin qui est dopé par un premier type de conductivité,
- dans lequel la deuxième électrode de grille du transistor (19) respectif a du silicium polycristallin qui est dopé par un deuxième type de conductivité opposé au premier type,
- dans lequel la première électrode (18) de grille est voisine de la deuxième électrode (19) de grille.

11. Dispositif de cellule de mémoire suivant l'une des revendications 1 à 10,
dans lequel il est prévu dans le transistor ferroélectrique respectif une couche (17) auxiliaire entre la couche (16) ferroélectrique et la première électrode (18) de grille.

12. Dispositif de cellule de mémoire suivant l'une des revendications 1 à 11,
dans lequel, dans le transistor ferroélectrique respectif, la première couche intermédiaire de grille contient CeO₂, ZrO₂, Y₂O₃ ou SrTiO₃, la deuxième couche intermédiaire de grille SiO₂, CeO₂, ZrO₂ ou SrTiO₃, la couche (16) ferroélectrique du tantalate de strontium et de bismuth (SBT), du titanate de plomb et de zirconium (PZT), du niobate de lithium (LiNbO₃) ou du titanate de baryum et de strontium (BST) et le substrat (11) semi-conducteur du silicium monocristallin.
